# EUROPEAN PATENT APPLICATION

(11) **EP 4 660 718 A1**
(43) Date of publication of application: **10.12.2025**
(21) Application number: 24180596.9
(22) Date of filing: 06.06.2024
(51) Int. Cl.: G04F 5/06, G04G 3/00, H03H 9/02

(54) **RESONATOR FOR GENERATING AN ELECTRICAL SIGNAL**

(71) Applicant: Flexous Mechanisms IP B.V., 2629 JD Delft (NL)
(72) Inventor: Tolou, Nima, 2629 JD Delft (NL); Yellowhorse, Alden, 2629 JD Delft (NL)
(74) Representative: De Vries & Metman

(57) **Abstract**

The invention relates to an resonator a resonator (1) for generating an electrical signal, in particular for timekeeping in electronic devices, comprising at least two masses (2), a ground (3), and at least one actuator (5, 6) and/or sensor (7) to exchange power and/or information between at least one of the masses (2) and the ground (3) or between the masses (2), wherein at least two of the masses (2) are each individually connected to the ground (3) by one or more flexures (10) to enable the masses (2) to oscillate rotationally relative to the ground (3) and wherein at least two of the masses (2) are interlinked by one or more further flexures (11).

## Description

The invention relates to a resonator for generating an electrical signal, in particular for timekeeping in electronic devices, such as laptops, IoT (Internet of Things) devices, smartphones, wristwatches, e.g. smartwatches, sensing devices, e.g. for sensing tilt and/or acceleration, and/or radiofrequency (RF) devices, comprising at least two (vibratory) masses, a ground, e.g. for securing the resonator to a base plate or frame, and at least one actuator and/or sensor to exchange power and/or information between at least one of the masses and the ground or between the masses, wherein at least two of the masses are each individually connected to the ground by one or more flexures to enable the masses to oscillate rotationally relative to the ground.

US 2002/0020219 discloses a microelectromechanical sensor with an element that is driven into oscillations with drive forms through the use of arms, comb-drives, and corresponding comb-fingers and wherein a sense signal is transduced with capacitive sense electrodes. The drive forms are provided in four-phases and are applied in pairs that are 180 degrees out of phase with respect to one another such that the drive forms are substantially self-cancelling with regard to any drive form energy that feeds through any parasitic capacitance that connects the comb-drives to the capacitive sense electrodes.

US 2020/073329 discloses a device for a timepiece, comprising a support, an inertial regulating member mounted so as to rotate relative to the support by an elastic suspension connecting said regulating member to the support. The regulating member comprises a number n of rigid portions interconnected in pairs by n elastic coupling links. The elastic suspension comprises n elastic suspension links respectively connecting each rigid portion to the support.

Timekeeping clocks or oscillators are critical components of virtually all modern electronics because of the essential role that they play in devices ranging from supercomputers and spacecraft to smartphones, laptops and GPS. In each case, the clock produces a steady, periodic waveform which is used to time other operations occurring in the circuit or as a precursor signal for other operations.

In this context, the oscillator must fulfil a set of requirements for successful timing. Firstly, as explained in Pini, A. (2019, February) *How to select and effectively apply an oscillato,* it must produce a stable frequency that is resistant to environmental variation (Pini, 2019). This includes variation in frequency resulting from changing temperature. Additional requirements apply to the change in frequency with age (aging) and short-term variation in frequency (jitter). When these are satisfied, additional considerations like power consumption and device footprint must then be considered.

One drawback of modern clock generators and oscillators is that they require elaborate electronics and/or processing steps to achieve high-frequency stability in changing environments. These circuits compensate for temperature, regulate voltage and regulate amplitude among other tasks. This increases chip footprint by several times. Additional circuitry also means that a single oscillator has a power consumption that ranges from roughly 1 µW to 1 mW. This translates into a substantial energy cost in low-power applications such as IoT and other battery-powered devices.

It is an object of the present invention to provide an improved resonator, in particular a resonator having a small form factor and/or a resonator that provides more accurate time keeping or sensing.

To this end, in the resonator according to the present invention, at least two of the masses are interlinked by one or more further flexures.

In an embodiment, the resonator comprises at least two actuators and/or sensors, to exchange power and/or information between at least one of the masses, preferably two of the masses, and the ground or between the masses.

The resonator according to the present invention provides relatively high inherent stability and/or accuracy, and allows a relatively small chip footprint, if the latter is desired or required in a particular design. The relatively high inherent stability and/or accuracy in turn allows the use of relatively straightforward circuitry to control the resonator, in turn providing a relatively low power consumption oscillator, in principle even when compared to standard quartz and silicon oscillators. In this context, an oscillator is defined as an electromechanical resonator including an electrical circuit that controls the resonator.

In an embodiment, at least one of the at least two masses, preferably two of the masses, are each individually connected to the ground by two or more flexures to enable the masses to oscillate rotationally relative to the ground.

Suspending the masses from the ground by two (or more) flexures reduces or cancels translation and torsion, providing essentially one degree of freedom, typically a rotational oscillation about an axis perpendicular to the plane of the resonator.

To synchronize the oscillations and/or compensate non-linearity and achieve even higher accuracy, in an embodiment, in an embodiment, the further flexures between the masses, interconnecting the masses and not connecting the masses to the ground, comprise one or more sets of parallel flexures, e.g. two sets, allowing translation of the interlinked masses relative to each other and essentially preventing rotation between the interlinked masses. In an embodiment, these further flexures impose on the at least two masses a specific mode of oscillation, preferably a mode wherein the masses oscillate in the same direction.

In an embodiment, at least one, preferably at least two of the flexures between the masses is (are) connected to the ground by yet one or more further flexures, e.g. a single further flexure.

In an embodiment, the further flexure imposes on the at least two masses a specific mode of oscillation, preferably a mode wherein the masses oscillate in opposite directions, in particular, wherein, when one of the masses rotates clockwise, the other rotates counterclockwise, and vice versa.

Linking the masses to each other by further flexures and optionally also linking the further flexures to the ground reduces and/or tunes the non-linear phenomena in the oscillations of the masses. This is particularly important for maintaining precision and/or accuracy at diffent amplitudes of oscilations and/or for achieving high signal to nosie ratio. This is especially important when the resonator is operatively connected to an amplifier circuit. In that case, noise and/or distortions that are generated in the resonator and picked up by the sensor are amplified and fed to the resonator. The result is that a non-linear resonator will add to noise in the system. Removing or reducing and/or tuning this non-linearity will allow the resonator to better filter out any noise from the amplifier and produce a more accurate output signal. It also helps to maintain high signal to noise ratio after process steps, such as silicon oxidation, to obtain temperature compensation.

In an embodiment, the at least two masses, and preferably also the flexures with which they are resiliently connected to the ground and the further flexures (interlinking the masses) are rotationally symmetrical and/or mirror symmetrical.

In an embodiment, the at least two masses are arranged to oscillate about at least two parallel axes or about essentially the same (virtual) axis of rotation.

These features enable low orientational error, i.e. sensitivity to change of gravity direction, in particular when the centre of gravity of the masses combined coincides with the centre of the (virtual) rotational axes, e.g. in case of two axes halfway these axes.

In an embodiment, packaging, e.g. a housing, protects the resonator from out of plane shocks and/or the resonator comprises internal limiters, e.g. stoppers, that protect the resonator from in plane shocks. In an example, the resonator is positioned between top and bottom plates that limit out of plane motion of the masses to avoid overstressing the flexures or other parts of the resonator resulting from shocks in an out of plane direction. In another example, the resonator is provided with internal motion limiters, e.g. in the resonator design, e.g. positioned within the circumference and thickness of the resonator, in particular to limit the motion of masses to avoide mechanical failure resulting from shocks in an in-plane direction.

In an embodiment, the actuators and/or sensors are electrostatic, e.g. electrostatic combs, electret, or piezoelectric.

In an embodiment, to reduce production costs and unwanted effects of inertia, the actuators and/or sensors, the masses, and the flexures are planar, i.e. the resonator is flat, of twodimensional design, and has a unifom thickness.

In an embodiment, at least one of the actuators and/or sensors is a so-called electrostatic comb. In an embodiment, one of the masses comprises an electrostatic actuator comb for driving the resonator masses and at least one of the other masses comprises an electrostatic sensor comb for sensing the oscillation of the masses.

In an embodiment, the resonator is monolithic, i.e. made from a single piece of material and thus formed as a single component, and/or the resonator is shaped by means of etching, such as reactive ion etching or deep reactive ion etching, lithography, electroplating, molding, or laser cutting and/or is made from silicon or metal.

In an embodiment, the resonator has a diameter smaller than 30 mm (millimeters), preferably in a range from 0.1 to 15 mm.

In an embodiment, the resonator has a thickness smaller than 700 µm, preferably smaller than 550 µm, preferably in a range from 10 µm to 500 µm, preferably in a range from 50 µm to 300 µm.

In an embodiment the resonator has an amplitude in a range from 0,1° to 45° preferably smaller than 10°, preferably smaller than 6°, e.g. in range from 0.5° to 3°.

In an embodiment, the resonator has a natural frequency of 1 Hertz (Hz) or higher, preferably 10 Hz or higher, preferably in a range from 30 to 5MHz, and preferably a power of 2 (2^N where N is an integer), such as 2Hz, 32Hz, 64Hz, 1.024Hz, 32.768 Hz, or 1.048.576 Hz.

The invention also relates to a device, in particular a device for timekeeping in electronic devices, such as laptops, IoT devices, smartphones, wristwatches, e.g. electric watches and smartwatches, sensing devices, e.g. for sensing tilt and/or acceleration, and/or radiofrequency (RF) devices, comprising an resonator as described above.

WO 2019/156552 discloses a mechanical watch oscillator comprising a platform provided with at least two vibratory masses that are individually suspended on the platform with at least one flexural member. The at least two vibratory masses are interconnected by two parallel flexural beams providing a direct torsion stiff connection between these at least two vibratory masses. A first mass of the at least two masses and the at least one flexural member that provides a connection of the first mass to the platform is mirror symmetric with reference to a second mass of the at least two masses and the at least one flex-ural member that provides a connection of the second mass to the platform.

Below, the invention will be explained further, which reference to the appended figures in which an embodiment of the invention is shown.
Figure 1 shows a top plan view of a first example of a resonator according to the present invention.
Figure 2A shows CW and CCW (extreme) positions of an oscillation of the resonator shown in Figure 1.
Figure 2B shows CW and CCW (extreme) positions of an oscillation of a resonator similar to the one shown in Figure 1.
Figure 3 shows a top plan view of a second example of a resonator according to the present invention.
Figure 4A illustrates an electrically conductive layer for juxtaposition on the resonator shown in Figures 1 to 2A.
Figure 4B is a block diagram illustrating an oscillator comprising a resonator according to the present invention and an ampflier.

The Figures are schematic, not necessarily to scale and details that are not required for understanding the present invention may have been omitted. Terms such as "up", "down", "above", "below", relate to the embodiments as oriented in the drawings, unless otherwise specified. Further, elements that are at least substantially identical or that perform an at least substantially identical function are denoted by the same numeral.

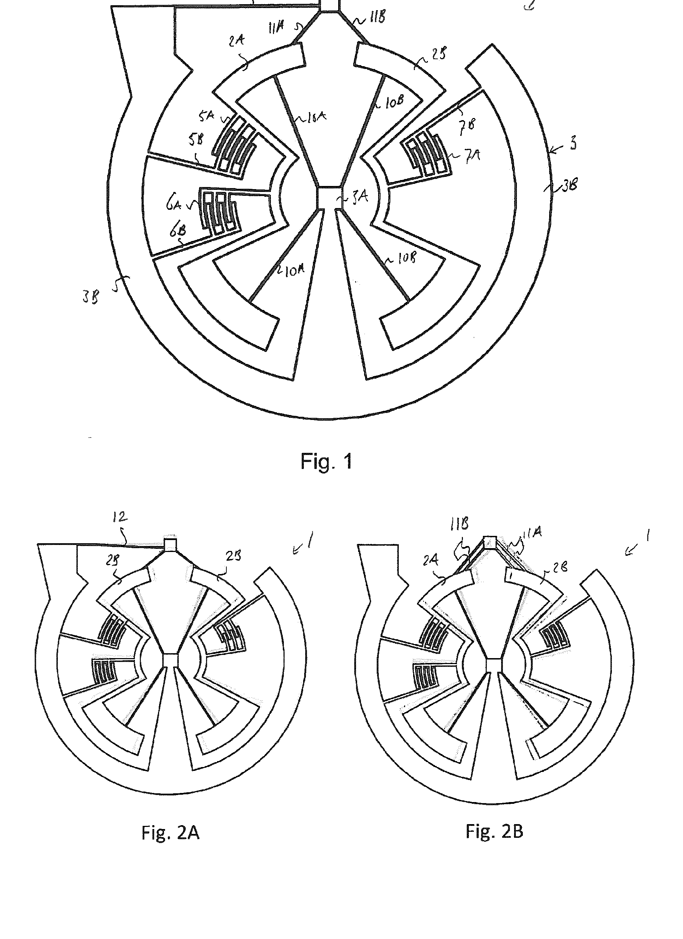

Figure 1 shows a resonator 1 according to the present invention comprising two vibratory masses 2A, 2B, and a ground 3. The ground has a central portion 3A in the middle of the resonator and a circumferencial portion 3B partially surrounding the masses 2A, 2B. At least one capacitative actuator, in this example two electrostatic combs 5A/B, 6A/B, are defined between the circumferential portion of the ground and one of the masses, to exchange power between the ground 3 and the masses 2A, 2B, more specifically to drive the masses and maintain resonance, in a manner known in itself. The resonator 1 also comprises a capacitative sensor, in this example an electrostatic comb 7A/B, to exchange information (signal) between the other of the masses and the ground, also in a manner known in itself. The information is amplified and filtered and used to adjust the driving of the resonator to a constant frequency. To this end, the resonator in combined with amplication circuitry (not shown and known in itself), which combination forms an oscillator.

Each the masses is individually connected to the ground by two flexures 10A, 10B, extending substantially radially from the central portion 3A of the ground, to enable the masses to oscillate rotationally relative to the ground. The masses are interlinked by one or more further flexures 11A, 11B, i.e. the one or more further flexures interconnect the masses but to connecting the masses to the ground 3. These flexures between the masses in turn are connected to the circumferential portion 3B of the ground 3 by yet a further flexure 12.

The further flexure is configured to impose on the at least two masses a specific mode of oscillation. Figure 2A illustrates a mode wherein the masses oscillate in opposite directions, in particular, wherein, when one of the masses rotates clockwise, the other rotates counterclockwise, and vice versa. In this Figure, the rest position is indicated by gray lines, whereas one of the extreme positions, wherein the massed have moved inwards, is indicated by black lines. Figure 2B illustrates variant wherein no flexure is present between the ground and the further flexures and comprising two sets of parallel further flexures 11 between masses 2 imposing a mode wherein the masses oscillate in the same direction.

Linking the masses to each other and optionally also linking the further flexures to the ground reduces non-linear phenomena in the oscillations of the masses. This is especially important when the resonator is operatively connected to an amplifier circuit, which inherently also amplifies unwanted information and noise.

The resonator in Figures 1 to 2B was etched by means of DRIE from a silicon wafer having a thickness of 500 µm, and has a diameter of 300 µm, a natural frequency of 32.768 Hz, an inertia of 2.8x10e-17 kg.m2, a stiffness of 1.2x10-6 Nm/rad, a maximum strain energy of 1.4x10e-10 J, an amplitude of 0,9 degrees, and a very favorable Q factor of 30e3, as well as a power loss from damping in free oscillation of 1 nW (in ambient conditions).

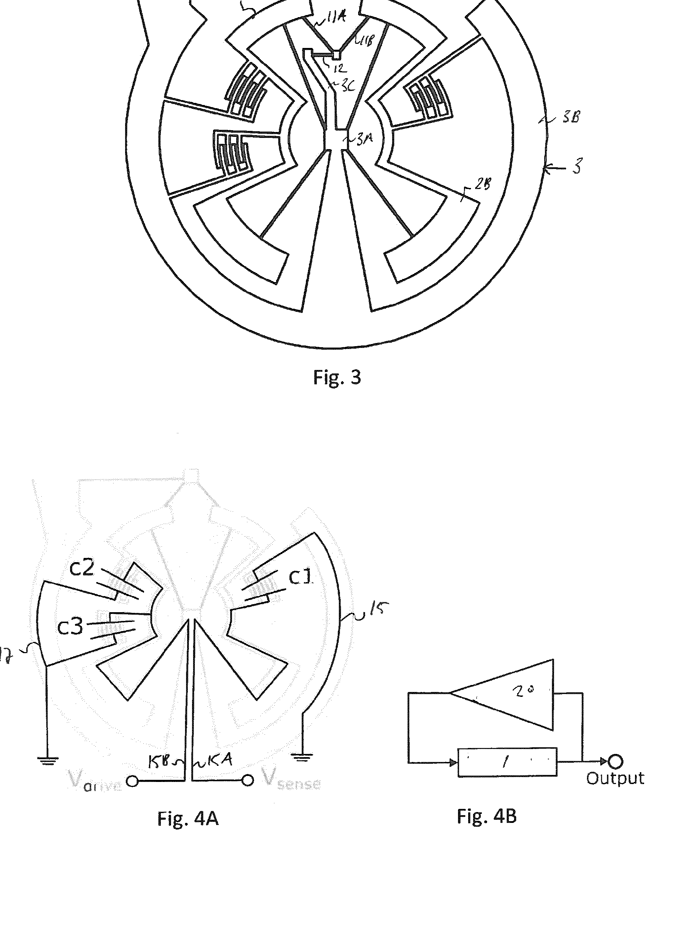

Figure 3 shows another variant of the resonator shown in Figure 1. In this variant, the vibratory masses are again interlinked by two further flexures 11A, 11B, via a rigid portion 13, but also by additional further flexures 11A, 11B. These additional flexures in turn are connected, by yet a further flexure 12, to the central portion 3A of the ground 3, which, to that end, comprises a rigid arm 13C extending towards the additional flexures 11A, 11B interlinking the vibratory masses and between two of the flexures 10A, 10B connecting the vibratory masses to the ground.

Figure 4 schematically shows the conductive leads c1 defining the capacitative sensor 7A/7B in Figure 1, the conductive leads c2, c3 defining the capacitative actuators 5A/B and 6A/B, and the leads 15, 17 connecting one side of the capacitors c1-c3 to a ground and the lead 15A, 17A connecting the other side of the capacitors c1-c3 to a voltage source. The input voltage "V_drive" is supplied with a voltage from the "Output" of the amplifier 20 shown in the block diagram in Figure 4B. This starts the movement of the resonator. As the resonator 1 moves, current is delivered to the terminal "V_sense". This current is connected to the output of the oscillator and to the input of the amplifier. This ensures that the resonator is driven with positive feedback from the amplifier and that the driving signal is synchronized with the motion of the resonator.

The resonators according to the present invention provide relatively high inherent stability and/or accuracy, and allow a relatively small chip footprint, if the latter is desired or required in a particular design. The relatively high inherent stability and/or accuracy in turn allows the use of straightforward circuitry to control the resonator, thus providing low power consumption oscillators, even when compared to standard quartz and silicon oscillators.

The invention is not limited to the described embodiments and can be varied within the scope of the claims.

## Claims

1. Resonator (1) for generating an electrical signal, in particular for timekeeping in electronic devices, comprising at least two masses (2), a ground (3), and at least one actuator (5, 6) and/or sensor (7) to exchange power and/or information between at least one of the masses (2) and the ground (3) or between the masses (2), wherein at least two of the masses (2) are each individually connected to the ground (3) by one or more flexures (10) to enable the masses (2) to oscillate rotationally relative to the ground (3) and wherein at least two of the masses (2) are interlinked by one or more further flexures (11).

2. Resonator (1) according to claim 1, wherein at least one of the at least two masses (2), preferably two of the masses (2), are each individually connected to the ground (2) by two or more flexures (10) to enable the masses (2) to oscillate rotationally relative to the ground (3).

3. Resonator (1) according to claim 1 or 2, wherein the one or more further flexures (11) between masses (2) is/are configured to impose on the at least two masses (2) a specific mode of oscillation, preferably a mode wherein the masses oscillate in the same direction.

4. Resonator (1) according to any one of the preceding claims, wherein the flexures (11) between the masses (2) comprise one or more sets of parallel flexures, preferably at least two sets of parallel flexures.

5. Resonator (1) according to any one of the preceding claims, wherein at least one of the flexures (11) between the masses (2) is connected to the ground (3) by yet one or more further flexures (12).

6. Resonator (1) according to claim 5, wherein the yet further flexure(12) is configured to impose on the at least two masses (2) a specific mode of oscillation, preferably a mode wherein the masses oscillate in opposite directions.

7. Resonator (1) according to any one of the preceding claims, wherein the at least two masses (2), and preferably also the flexures (10) with which they are resiliently connected to the ground (3) and the further flexures (11) are rotationally symmetrical and/or mirror symmetrical.

8. Resonator (1) according to any one of the preceding claims, wherein the at least two masses (2) are arranged to oscillate about at least two parallel axes and/or about essentially the same axis of rotation and/or at at least essentially the same frequency.

9. Resonator (1) according to any one of the preceding claims, wherein packaging protects the resonator from out of plane shocks and/or the resonator comprises internal limiters that protect the resonator from in plane shocks.

10. Resonator (1) according to any one of the preceding claims, wherein the actuators (5, 6) and/or sensors (7) are electrostatic, electret, or piezoelectric.

11. Resonator (1) according to any one of the preceding claims, wherein the resonator (1) is monolithic and/or wherein the resonator (1) is shaped by means of etching, such as reactive ion etching or deep reactive ion etching, lithography, electroplating, molding, or laser cutting and/or is made from silicon or metal.

12. Resonator (1) according to any one of the preceding claims, wherein the resonator has a diameter smaller than 30 mm (millimeters), preferably in a range from 0.1 to 15 mm, and/or wherein the resonator has a thickess smaller than 700 µm (micrometers), preferably in a range from 10 to 500 µm.

13. Resonator (1) according to any one of the preceding claims, wherein the resonator (1) has an amplitude in a range from 0,1° to 45° preferably smaller than 10°, preferably smaller than 6°, e.g. in range from 0.5° to 3°.

14. Resonator (1) according to any one of the preceding claims, wherein the resonator (1) has a natural frequency of 1 Hertz (Hz) or higher, preferably 8 Hz or higher, preferably in a range from 32 to 8MHz, and preferably a power of 2.

15. Device, in particular a device for timekeeping in electronic devices, such as laptops, IoT devices, smartphones, wristwatches, e.g. electric watches and smartwatches, sensing devices, e.g. for sensing tilt and/or acceleration, and/or radiofrequency (RF) devices and/or for real time clock, comprising an resonator (1) according to any one of the preceding claims.
